(19) Europäisches Patentamt / European Patent Office / Office européen des brevets

(11) **EP 2 339 595 B1**

(12) **EUROPÄISCHE PATENTSCHRIFT**

(45) Veröffentlichungstag und Bekanntmachung des Hinweises auf die Patenterteilung:
**18.02.2015 Patentblatt 2015/08**

(51) Int Cl.:
*H01F 1/03* *(2006.01)* *H01L 41/20* *(2006.01)*
*C22C 19/00* *(2006.01)* *C22C 19/05* *(2006.01)*

(21) Anmeldenummer: **09015426.1**

(22) Anmeldetag: **14.12.2009**

(54) **Magnetisches Formgedächtnislegierungsmaterial**

Magnetic shape memory alloy material

Matériau d'alliage de mémoire de forme magnétique

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**29.06.2011 Patentblatt 2011/26**

(73) Patentinhaber: **ETO MAGNETIC GMBH**
78333 Stockach (DE)

(72) Erfinder:
• **Laufenberg, Markus, Dr.**
78333 Stockach (DE)
• **Pagounis, Emmanouel, Dr.**
78315 Radolfzell (DE)

(74) Vertreter: **Behrmann, Niels et al**
**Behrmann Wagner Partnerschaftsgesellschaft mbB**
**Patentanwälte**
**Hegau-Tower**
**Maggistraße 5 (10. OG)**
**78224 Singen (DE)**

(56) Entgegenhaltungen:
**WO-A1-2009/147135     JP-A- 2002 285 269**
**US-B1- 6 475 261**

EP 2 339 595 B1

**Beschreibung**

Die vorliegende Erfindung betrifft ein magnetisches Formgedächtnislegierungsmaterial, ein aus einem solchen Formgedächtnislegierungsmaterial hergestelltes Aktorenelement sowie eine Verwendung eines solchen Materials bzw. eines solchen Aktorenelementes.

Aus dem Stand der Technik sind Materialien, die als Reaktion auf eine Beaufschlagung mit einem Magnetfeld ihre Form ändern, seit längerer Zeit bekannt. Derartige Materialien werden typischerweise als magnetoplastische Materialien, als MSMA (Magnetic Shape Memory Alloys) oder aber als FSMA (Ferromagnetic Shape Memory Alloys) bezeichnet; für den Zweck der vorliegenden Offenbarung soll der Begriff "magnetische Formgedächtnislegierung" bzw. "magnetisches Formgedächtnislegierungsmaterial" als Begriff für ein Legierungsmaterial verwendet werden, welches bei Beaufschlagung mit einem Magnetfeld in zumindest einer Richtung eine Längen- und/oder Formänderung durchführt.

Aus dem Stand der Technik sind diesbezüglich verschiedene Legierungen bekannt, welche in der Art einer (ferro-)magnetischen Formgedächtnislegierung, induziert durch ein äußeres magnetisches Feld, Dehnungen im Bereich einiger Prozent (bezogen auf eine Abmessung eines jeweiligen Körpers aus dem Formgedächtnislegierungsmaterial) zeigen.

Aus dem Stand der Technik ist bekannt, dass FePd-Legierungen, ferner NiMnGa-Legierungen und auch Ni-FeGa-Legierungen ein derartiges magnetfeldinduziertes Dehnungsverhalten zeigen.

Allerdings ist die Einsatztemperatur sowie damit die technische Verwendbarkeit derartiger Legierungen begrenzt durch die sogenannte Curietemperatur ($T_c$), ab der das Material nicht mehr ferromagnetisch ist, sowie begrenzt durch die sogenannte Phasenumwandlungstemperatur, bei der die Umwandlung einer martensitischen Phase des Materials in eine austenitische Phase stattfindet. Oberhalb halb jeder dieser Temperaturgrenzen tritt der beabsichtigte und etwa für Stellglieder ausgenutzte magnetische induzierte Dehnungseffekt nicht mehr auf, so dass die niedrigere dieser beiden Temperaturen die Einsatzgrenze für ein jeweiliges Material bzw. eine daraus realisierte Anwendung beschreibt.

Bei bekannten magnetischen Formgedächtnismaterialen liegt die niedrigere der beiden Temperaturen TC und TA typisch bei Werten von bis zu 65°C, so dass insbesondere der industrielle Einsatz bzw. eine besonders wünschenswerte Anwendbarkeit derartiger Materialien im Zusammenhang mit Aktoren im Kraftfahrzeugbereich ausscheidet; so würden etwa die im Motorraum eines Kraftfahrzeugs herrschenden Betriebstemperaturen regelmäßig diese Temperaturgrenze übersteigen, so dass ein zuverlässiger Aktorenbetrieb mit Hilfe der Formgedächtnislegierungsmaterialien nicht mehr gewährleistet ist.

Aus der JP 2002 285 269 A (Dido Steel Co.Ltd.) dort insbesondere Tabelle 6, ist ein Legierungsmaterial bekannt, welches Ni, Nn, Ga, aufweist und zusätzlich Co vorhanden ist.

Aufgabe der vorliegenden Erfindung ist es daher, ein (ferro-)magnetisches Formgedächtnislegierungsmaterial zu schaffen, welches eine gegenüber dem Stand der Technik erhöhte Curietemperatur sowie erhöhte Phasenübergangstemperatur aufweist, dabei gleichzeitig hohe magnetfeldinduzierte Dehnungseigenschaften besitzt und sich somit insbesondere für Anwendungen in Umgebungen eignet, in denen höhere Temperaturen, insbesondere Temperaturen oberhalb von 65°C, weiter bevorzugt Temperaturen oberhalb von 80°C und noch weiter bevorzugt Temperaturen von oberhalb von 100°C, herrschen. Ferner ist ein Aktorenelement basierend auf einem solchen Formgedächtnislegierungsmaterial zu schaffen, und es ist eine Verwendung für ein solches Aktorenelement sowie für ein solches Formgedächtnislegierungsmaterial zu schaffen.

Die Aufgabe wird durch das magnetische Formgedächtnislegierungsmaterial mit den Merkmalen der Hauptansprüche 1 und 3, das Formgedächtniselement (Aktorelement) nach dem unabhängigen Patentanspruch 11 sowie die Verwendung nach den Patentansprüchen 12 und 13 gelöst; vorteilhafte Weiterbildungen der Erfindung sind in den Unteransprüchen beschrieben.

In erfindungsgemäß vorteilhafter Weise besitzt das erfindungsgemäße Formgedächtnislegierungsmaterial eine Basis bestehend aus NiMnGa mit den durch die Parameter a, b, c gemäß Hauptanspruch spezifizierten Anteilsbereichen in Atom-%. Zusätzlich weist das erfindungsgemäße Legierungsmaterial zumindest Co auf, wobei das Co auch in Kombination mit Fe und/oder Cu vorliegen kann, gemäß den im Hauptanspruch mit den Parametern d, e, f vorgegebenen Anteilsbereichen in Atom-%, wobei die Basis bestehend aus NiMnGa einen Anteil (in Atom-%) von zumindest 85 % aufweist, und wobei in der Praxis typischerweise auftretende Verunreinigungen mit sonstigen Elementen in den Anteilszusammensetzungen unberücksichtigt gelassen wurden.

In erfindungsgemäß vorteilhafter Weise hat sich nämlich herausgestellt, dass ein (begrenzter, d.h. unter 15 % liegender) Anteil von Kobalt an der Formgedächtnislegierung sich günstig auf eine hohe Curietemperatur sowie Phasenübergangstemperatur auswirkt, wobei eine magnetfeldinduzierte Dehnung weiterhin auftritt. Der erfindungsgemäßen Weiterbildung haben sich gar Kobalt-Anteile (in Atom-%) von weniger als 6% an der Gesamtlegierung, noch weiter < 3% an der Gesamtlegierung, als besonders günstig und vorteilhaft herausgestellt, wobei besonders gute Ergebnisse erzielt wurden, wenn Kobalt entweder ohne Fe und ohne Cu in der Legierung auftrat, oder lediglich in Kombination mit Fe in der Legierung in Verbindung mit der anspruchsgemäß vorgegebenen NiMnGa-Basis vorhanden war.

In der Praxis ließ sich so eine Curietemperatur sowie eine Phasenübergangstemperatur des erfindungsgemäßen ferromagnetischen Formgedächtnislegierungsmaterials realisieren, welche oberhalb von 65°C lag, wobei besonders günstige Kombinationen oberhalb von 80°C, oberhalb von 100°C oder sogar oberhalb von 120°C lagen, so dass diesbezüglich ein Einsatz in Hochtemperaturumgebungen erstmals mittels einer auf magnetischen Formgedächtnislegierungen basierenden Aktorik machbar und sinnvoll erscheint.

Darüber hinaus ließ sich im Rahmen der Erfindung vorteilhaft beobachten, dass gemäß der Erfindung hergestellte Formgedächtnislegierungsmaterialien pro- zentuale Dehnungen (bezogen auf ein Ausgangsmaß entlang mindestens einer Dimension ohne Magnetfeldbeaufschlagung) im Bereich zwischen 0,1% und mehr als 6% unbelastet ermöglichten (freie magnetfeldinduzierte Dehnung), wobei dieses Dehnungsverhalten in der erwarteten Weise temperaturabhängig ist und insbesondere oberhalb kritischer Temperaturen von 65°C bzw. 80°C die genannten Mindestdehnungen erreicht. Auch lassen sich vergleichbare magnetfeldinduzierte Dehnungen bei den genannten Temperaturen unter mechanischer Vorspannung, typischerweise > 0,1 MPa, bevorzugt > 0,5 MPa, weiter bevorzugt $\geq$ 2 MPa, erreichen.

Damit eignet sich die vorliegende Erfindung in besonders günstiger Weise zum Herstellen eines Aktorenelementes, welches als (magnetisches) Stellglied durch geeignete Kombination mit einem Magnetfelderzeuger, etwa einer Spuleneinheit, zu vielfältigen Stellzwecken im Kraftfahrzeug-, industriellen- und anderen Bereichen eingesetzt werden kann, wobei insbesondere, wie oben erwähnt, die günstigen Temperatureigenschaften einen Einsatz oberhalb von 65°C, bevorzugt oberhalb von 80°C, 100°C und weiter bevorzugt oberhalb von 120°C ermöglichen.

Dabei ist die vorliegende Erfindung nicht auf das Herstellen von Aktorenelementen als mono- oder polykristallinen Körper beschränkt, vielmehr ist es von der Erfindung umfasst und in der Weiterbildung möglich, einen geschäumten Körper, ein Pulver, eine (Dünn-)Filmschicht, ein Band oder auf andere Weise das Material, etwa in Verbindung mit anderen Materialien als Verbundstoff, herzustellen.

Im Ergebnis lässt sich durch die vorliegende Erfindung in überraschender, gleichwohl einfacher Weise die Temperaturgrenze herkömmlicher magnetischer Formgedächtnislegierungsmaterialien signifikant nach oben erhöhen, so dass erfindungsgemäß realisierte Formgedächtnislegierungsmaterialien bzw. damit realisierte Aktoren neue Stellanwendungen, insbesondere in Hochtemperaturumgebungen, eröffnen.

Weitere Vorteile, Merkmale und Einzelheiten der Erfindung ergeben sich aus der nachfolgenden Beschreibung bevorzugter Ausführungsbeispiele sowie der genannten Rezepte und Verfahrensanwendungen.

Beispiel 1:

Ein Formgedächtnismaterial

$$Ni_{49,4}Mn_{27,6}Ga_{20,9}Co_{2,0}$$

d.h. a = 49,4; b = 27,6; c = 20,9; d = 2,0; e = 0; f = 0 im Sinne des Hauptanspruchs, wurde aus elementaren Ausgangsmaterialien durch Abwiegen zunächst als Mischung erstellt und dann durch Induktionsschmelzen aufgeschmolzen.

Mit Hilfe des sogenannten Bridgman-Verfahrens (siehe etwa D.L. Schlagel, Y.L. Wu, W. Zhang, T.A. Lograsso: Chemical segregation during bulk single crystal preparation of Ni-Mn-Ga ferromagnetic shape memory alloys, Journal of Crystal Growth, vol. 312 (2000) Seiten 77-85 oder A.J. Elliott, T.M. Pollock: Thermal analysis of the Bridgman and Liquid-Metal-Cooled directional solidification investment casting processes, Metallurgical and Materials Transactions A, vol. 38 (2007), Seiten 871-882, beide Quellen gelten im Hinblick auf die darin beschriebenen Vorgehensweisen zur Kristaliherstellung als zur Erfindung gehörig in die vorliegende Offenbarung einbezogen) wurde ein einkristalliner Körper hergestellt. Dieser Körper wurde zwecks chemischer Homogenisierung bei einer Temperatur oberhalb von 700°C wärmebehandelt. Anschließend wurde ein quaderförmiges Formgedächtniselement mittels Drahterodieren aus diesem Körper geschnitten. Die magnetfefdinduzierte Formänderung dieses Elements wurde anschließend bei verschiedenen Temperaturen untersucht. Dazu wurden die geometrischen Abmessungen des Quaders vor und nach der Beaufschlagung mit einem Magnetfeld ermittelt und daraus die relative Längenänderung des quaderförmigen Elements bei verschiedenen Temperaturen bestimmt.

Das Element zeigte eine magnetfeldinduzierte freie Dehnung von > 1,0% bei allen gemessenen Temperaturen zwischen 25 °C und 102 °C. Die CurieTemperatur $T_C$ lag bei 107°C, die Phasenübergangstemperatur $T_A$ bei 112 °C.

Beispiel 2:

Weitere Formgedächtnismaterialien gemäß folgender Tabelle wurden analog zum Vorgehen gemäß Beispiel 1 hergestellt und wiesen die angegebenen Temperatureigenschaften auf:

| Ni (atom%) | Mn (atom%) | Ga (atom%) | Co (atom%) | Fe (atom%) | Cu (atom%) | $T_C$ (°C) | $T_A$ (°C) |
|---|---|---|---|---|---|---|---|
| 47,4 | 25,8 | 21,6 | 5,1 | 0,0 | 0,0 | 136 °C | 103 °C |
| 48,7 | 27,8 | 19,4 | 2,0 | 2,1 | 0,0 | 129 °C | 136 °C |
| 48,2 | 27,1 | 20,7 | 2,9 | 1,1 | 0,0 | 127 °C | 107 °C |

**Patentansprüche**

1. Magnetisches Formgedächtnislegierungsmaterial mit einer Curietemperatur (TC) sowie einer Phasenübergangstemperatur (TA) von einer martensitischen in eine austenitische Phase, aufweisend Ni, Mn, Ga sowie mindestens Co in der Zusammensetzung
$Ni_aMn_bGa_cCO_dFe_eCu_f$, wobei a, b, c, d, e und f in Atom-% angegeben sind und die Bedingungen

$$44 \leq a \leq 51;$$

$$19 \leq b \leq 30;$$

$$18 \leq c \leq 24;$$

$$0{,}1 \leq d < 3;$$

$$0 \leq e \leq 14{,}9;$$

$$0 \leq f \leq 14{,}9;$$

$$d+e+f \leq 3;$$

$$a+b+c+d+e+f = 100;$$

erfüllen.

2. Material nach Anspruch 1, **dadurch gekennzeichnet, dass** entweder e > 0 und f = 0 gilt, oder e = 0 und f > 0 gilt.

3. Magnetisches Formgedächtnislegierungsmaterial mit einer Curietemperatur (TC) sowie einer Phasenübergangstemperatur (TA) von einer martensitischen in eine austenitische Phase, aufweisend Ni, Mn, Ga sowie mindestens Co in der Zusammensetzung
$Ni_aMn_bGa_cCO_dFe_eCu_f$, wobei a, b, c, d, e und f in Atom-% angegeben sind und die Bedingungen

$$44 \leq a \leq 51;$$

$$19 \leq b \leq 30;$$

$$18 \leq c \leq 24;$$

$$0{,}1 \leq d \leq 15;$$

$$0 \leq e \leq 14{,}9;$$

$$0 \leq f \leq 14{,}9;$$

$$d+e+f \leq 15;$$

$$a+b+c+d+e+f = 100;$$

erfüllen,
**dadurch gekennzeichnet, dass**
entweder $e > 0$ und $f = 0$ gilt,
oder $e = 0$ und $f > 0$ gilt,
oder $e > 0$ und $f > 0$ gilt,
oder $d \leq 5{,}1$ gilt.

4. Material nach einem der Ansprüche 1 bis 3, **dadurch gekennzeichnet, dass** $0{,}5 \leq d+e+f \leq 3$, gilt.

5. Material nach einem der Ansprüche 1 bis 4, **dadurch gekennzeichnet, dass** die Curietemperatur und die Phasenübergangstemperatur von der martensitischen in die austenitische Phase jeweils oberhalb von 65°C, bevorzugt oberhalb von 80°C, weiter bevorzugt oberhalb von 100°C und noch weiter bevorzugt oberhalb von 120°C liegen.

6. Material nach einem der Ansprüche 1 bis 5, **dadurch gekennzeichnet, dass** die Curietemperatur höher als die Phasenübergangstemperatur ist, bevorzugt um mindestens 10 K höher, weiter bevorzugt um mindestens 20 K höher.

7. Material nach einem der Ansprüche 1 bis 6, **dadurch gekennzeichnet, dass** ein aus dem Material hergestellter Körper bei einer Magnetfeldbeaufschlagung mit höchstens 2 T bei einer Temperatur oberhalb von 65°C, bevorzugt oberhalb von 80°C, weiter bevorzugt oberhalb von 100°C und noch weiter bevorzugt oberhalb von 120°C eine freie magnetfeldinduzierte Dehnung von > 0,1%, bevorzugt > 1 %, weiter bevorzugt > 3% und noch weiter bevorzugt > 6% aufweist.

8. Material nach einem der Ansprüche 1 bis 7, **dadurch gekennzeichnet, dass** ein aus dem Material hergestellter Körper bei einer Magnetfeldbeaufschlagung von höchstens 2 T bei einer Temperatur oberhalb von 65°C, bevorzugt oberhalb von 80°C, weiter bevorzugt oberhalb von 100°C und noch weiter bevorzugt oberhalb von 120°C eine magnetfeldinduzierte Dehnung von > 0,1 %, bevorzugt > 1%, weiter bevorzugt > 3% und noch weiter bevorzugt > 6% unter einer Vorspannung von mindestens 0,05 MPa und bevorzugt unter einer Vorspannung von 2 MPa aufweist.

9. Material nach einem der Ansprüche 1 bis 7, **dadurch gekennzeichnet, dass** das Material als einkristallines Material, insbesondere unter Verwendung eines Bridgman-Verfahrens, hergestellt ist.

10. Material nach einem der Ansprüche 1 bis 7, **dadurch gekennzeichnet, dass** das Material ein oligokristallines, polykristallines oder amorphes Material ist.

11. Formgedächtniselement, hergestellt aus dem Material nach einem der Ansprüche 1 bis 10 zur Verwendung als

**EP 2 339 595 B1**

Aktorelement in einem Aktor und/oder als Sensorelement in einem Sensor.

12. Verwendung des Materials nach einem der Ansprüche 1 bis 8 zum Herstellen eines Verbundmaterials, eines Pulvers, einer Dünnschichtstruktur, eines Bandes, von Fasern oder von Schäumen.

13. Verwendung eines Formgedächtniselements nach Anspruch 11 zum Realisieren einer Stell- und/oder Sensorvorrichtung für die Fahrzeugtechnik, für die Industrie- oder Medizintechnik und/oder die Messtechnik.

**Claims**

1. A magnetic shape-memory alloy material with a Curie temperature (TC) and also a phase transition temperature (TA) from a martensitic into an austenitic phase, exhibiting Ni, Mn, Ga and also at least Co in the compound $Ni_aMn_bGa_cCo_dFe_eCu_f$, wherein a, b, c, d, e and f are indicated as an atomic % and satisfy the conditions

$$44 \leq a \leq 51;$$

$$19 \leq b \leq 30;$$

$$18 \leq c \leq 24;$$

$$0.1 \leq d < 3;$$

$$0 \leq e \leq 14.9;$$

$$0 \leq f \leq 14.9;$$

$$d+e+f \leq 3;$$

$$a+b+c+d+e+f = 100.$$

2. The material according to claim 1, **characterized in that** either e > 0 and f = 0 or e= 0 and f > 0.

3. A magnetic shape-memory alloy material with a Curie temperature (TC) and also a phase transition temperature (TA) from a martensitic into an austenitic phase, exhibiting Ni, Mn, Ga and also at least Co in the compound $Ni_aMn_bGa_cCo_dFe_eCu_f$, wherein a, b, c, d, e and f are indicated as an atomic % and satisfy the conditions

$$44 \leq a \leq 51;$$

$$19 \leq b \leq 30;$$

$$18 \leq c \leq 24;$$

$$0.1 \leq d < 15;$$

$$0 \leq e \leq 14.9;$$

$$0 \leq f \leq 14.9;$$

$$d+e+f \leq 15;$$

$$a+b+c+d+e+f = 100,$$

**characterized in that**
either e > 0 and f = 0,
or e = 0 and f > 0,
or e > 0 and f > 0,
or $d \leq 5.1$.

4. The material according to one of the claims 1 to 3, **characterized in that** $0.5 \leq d + e + f \leq 3$.

5. The material according to one of the claims 1 to 4, **characterized in that** the Curie temperature and the phase transition temperature from the martensitic to the austenitic phase each lie above 65 °C, preferably above 80 °C, further preferably above 100 °C and still further preferably above 120 °.

6. The material according to one of the claims 1 to 5, **characterized in that** the Curie temperature is higher than the phase transition temperature, preferably by at least 10 K, further preferably by at least 20 K.

7. The material according to one of the claims 1 to 6, **characterized in that** a body made from the material exhibits a free magnetic field-induced expansion > 0.1 %, preferably > 1 %, further preferably > 3 % and yet further preferably > 6 %, during a magnetic field exposure with maximum 2 T at a temperature above 65 °C, preferably above 80 °C, further preferably above 100 °C and still further preferably above 120 °C.

8. The material according to one of the claims 1 to 7, **characterized in that** a body made from the material exhibits a magnetic field-induced expansion > 0.1 %, preferably > 1 %, further preferably > 3 % and still further preferably > 6 % under an initial stress of at least 0.05 MPa and preferably under an initial stress of 2 MPa with a magnetic field exposure of maximum 2 T at a temperature above 65 °C, preferably above 80 °C, further preferably above 100 °C and still further preferably above 120 °C.

9. The material according to one of the claims 1 to 7, **characterized in that** the material is produced as a monocrystalline material, in particular using a Bridgman method.

10. The material according to one of the claims 1 to 7, **characterized in that** the material is an oligo-crystalline, polycrystalline or amorphous material.

11. A shape-memory element produced from the material according to one of the claims 1 to 10 for use as the actuator element in an actuator and/or as the sensor element in a sensor.

12. Use of the material according to one of the claims 1 to 8 for producing a composite material, a powder, a thin-layer structure, a strip, of fibres or of foams.

13. Use of a shape-memory element according to claim 11 for realizing an actuator and/or sensor device for vehicle technology, for industrial and medical technology and/or measuring technology.

**Revendications**

1. Matériau d'alliage magnétique à mémoire de forme présentant une température de Curie (TC) ainsi qu'une température de transition de phase (TA) d'une phase martensitique en une phase austénitique, présentant Ni, Mn, Ga ainsi qu'au moins Co dans la composition
$Ni_aMn_bGa_cCo_dFe_eCu_f$, a, b, c, d, e et f étant indiqués en % en atome et satisfaisant aux conditions

$$44 \leq a \leq 51 \; ;$$

$$19 \leq b \leq 30 \; ;$$

$$18 \leq c \leq 24 \; ;$$

$$0,1 \leq d < 3 \; ;$$

$$0 \leq e \leq 14,9 \; ;$$

$$0 \leq f \leq 14,9 \; ;$$

$$d + e + f \leq 3 \; ;$$

$$a + b + c + d + e + f = 100.$$

2. Matériau selon la revendication 1, **caractérisé en ce que** soit e > 0 et f = 0, soit e = 0 et f > 0.

3. Matériau d'alliage magnétique à mémoire de forme présentant une température de Curie (TC) ainsi qu'une température de transition de phase (TA) d'une phase martensitique en une phase austénitique, présentant Ni, Mn, Ga ainsi qu'au moins Co dans la composition
$Ni_aMn_bGa_cCo_dFe_eCu_f$, a, b, c, d, e et f étant indiqués en % en atome et satisfaisant aux conditions

$$44 \leq a \leq 51 \; ;$$

$$19 \leq b \leq 30 \; ;$$

$$18 \leq c \leq 24 \; ;$$

$$0,1 \leq d \leq 15 \; ;$$

$$0 \leq e \leq 14,9 \; ;$$

$$0 \leq f \leq 14,9 \; ;$$

$$d + e + f \leq 15 \; ;$$

$$a + b + c + d + e + f = 100,$$

**caractérisé en ce que**
soit e > 0 et f = 0,
soit e = 0 et f > 0,
soit e > 0 et f > 0,
soit d $\leq$ 5,1.

4. Matériau selon l'une quelconque des revendications 1 à 3, **caractérisé en ce que** $0,5 \leq d + e + f \leq 3$.

5. Matériau selon l'une quelconque des revendications 1 à 4, **caractérisé en ce que** la température de Curie et la température de transition de phase de la phase martensitique dans la phase austénitique sont à chaque fois supérieures à 65°C, de préférence supérieures à 80°C, plus préférablement supérieures à 100°C et encore plus préférablement supérieures à 120°C.

6. Matériau selon l'une quelconque des revendications 1 à 5, **caractérisé en ce que** la température de Curie est supérieure à la température de transition de phase, de préférence supérieure d'au moins 10 K, plus préférablement supérieure d'au moins 20 K.

7. Matériau selon l'une quelconque des revendications 1 à 6, **caractérisé en ce qu'**un corps préparé à partir du matériau présente, à une sollicitation par un champ magnétique d'au plus 2 T à une température supérieure à 65°C, de préférence supérieure à 80°C, plus préférablement supérieure à 100°C et encore plus préférablement supérieure à 120°C, une dilatation libre induite par le champ magnétique > 0,1%, de préférence > 1%, plus préférablement > 3% et encore plus préférablement > 6%.

8. Matériau selon l'une quelconque des revendications 1 à 7, **caractérisé en ce qu'**un corps préparé à partir du matériau présente, à une sollicitation par un champ magnétique d'au plus 2 T à une température supérieure à 65°C, de préférence supérieure à 80°C, plus préférablement supérieure à 100°C et encore plus préférablement supérieure à 120°C, une dilatation libre induite par le champ magnétique > 0,1%, de préférence > 1%, plus préférablement > 3% et encore plus préférablement > 6% sous une précontrainte d'au moins 0,05 MPa et de préférence sous une précontrainte de 2 MPa.

9. Matériau selon l'une quelconque des revendications 1 à 7, **caractérisé en ce que** le matériau est préparé sous forme d'un matériau monocristallin, en particulier en utilisant un procédé de Bridgman.

10. Matériau selon l'une quelconque des revendications 1 à 7, **caractérisé en ce que** le matériau est un matériau oligocristallin, polycristallin ou amorphe.

11. Élément à mémoire de forme préparé à partir du matériau selon l'une quelconque des revendications 1 à 10 destiné à une utilisation comme élément d'actionneur dans un actionneur et/ou comme élément de capteur dans un capteur.

12. Utilisation du matériau selon l'une quelconque des revendications 1 à 8 pour la préparation d'un matériau composite, d'une poudre, d'une structure à couches minces, d'une bande, de fibres ou de mousses.

13. Utilisation d'un élément à mémoire de forme selon la revendication 11 pour la réalisation d'un dispositif de réglage et/ou de capteur pour la technique automobile, pour la technique industrielle ou médicale et/ou pour la technique de mesure.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   JP 2002285269 A

**In der Beschreibung aufgeführte Nicht-Patentliteratur**

*   **D.L. SCHLAGEL ; Y.L. WU ; W. ZHANG ; T.A. LO-GRASSO.** Chemical segregation during bulk single crystal preparation of Ni-Mn-Ga ferromagnetic shape memory alloys. *Journal of Crystal Growth,* 2000, vol. 312, 77-85

*   **A.J. ELLIOTT ; T.M. POLLOCK.** Thermal analysis of the Bridgman and Liquid-Metal-Cooled directional solidification investment casting processes. *Metallurgical and Materials Transactions A,* 2007, vol. 38, 871-882